# EUROPEAN PATENT APPLICATION

(11) **EP 4 726 930 A1**
(43) Date of publication of application: **15.04.2026**
(21) Application number: 24850908.5
(22) Date of filing: 01.08.2024
(51) Int. Cl.: H01R 13/02, H01R 13/502, H01R 12/71, H05K 1/18

(54) **ELECTRICAL CONNECTOR, CIRCUIT BOARD ASSEMBLY, AND ELECTRONIC DEVICE**

(30) Priority: 04.08.2023 CN 202310990627
(71) Applicant: Huawei Technologies Co., Ltd., Shenzhen, Guangdong 518129 (CN)
(72) Inventor: SHAN, Xiliang, Shenzhen, Guangdong 518129 (CN); ZOU, Lin, Shenzhen, Guangdong 518129 (CN); SU, Tien Chieh, Shenzhen, Guangdong 518129 (CN); PENG, Annan, Shenzhen, Guangdong 518129 (CN)
(74) Representative: Körber, Martin Hans
(86) International application number: PCT/CN2024/109298
(87) International publication number: WO 2025/031263

(57) **Abstract**

This application provides an electrical connector, a circuit board assembly, and an electronic device. The electrical connector includes an insulation housing and a terminal, the terminal is fastened to the insulation housing, an insertion space is provided inside the insulation housing, an opening is provided in a bottom surface of the insulation housing, the opening communicates the insertion space and an outside of the insulation housing, and the bottom surface of the insulation housing faces a circuit board. A first electrical connection end of the terminal is at least partially located in the insertion space and is configured to be electrically connected to a signal transmission structure, a second electrical connection end of the terminal extends out of the bottom surface of the insulation housing and is configured to be electrically connected to the circuit board, and when the electrical connector is configured to be electrically connected to the signal transmission structure, the signal transmission structure enters the insertion space through the opening and is connected to the first electrical connection end of the terminal. In this way, the electrical connector is electrically connected to the signal transmission structure and the circuit board on a side of the bottom surface. The signal transmission structure is fastened through cooperation between the circuit board and a surrounding structure, so that a press-fitting structure is omitted, effectively making the electrical connector smaller.

## Description

This application claims priority to Chinese Patent Application No. 202310990627.5, filed with the China National Intellectual Property Administration on August 4, 2023, and entitled "ELECTRICAL CONNECTOR, CIRCUIT BOARD ASSEMBLY, AND ELECTRONIC DEVICE", which is incorporated herein by reference in its entirety.

### TECHNICAL FIELD

This application relates to the field of terminal technologies, and in particular, to an electrical connector, a circuit board assembly, and an electronic device.

### BACKGROUND

With the continuous development of electronic devices, miniaturization gradually becomes a significant competitive advantage of electronic devices. Currently, in a common electronic device, a screen, various sensors, and the like are connected to a mainboard usually by using a flexible printed circuit (Flexible Printed Circuit, FPC) connection solution, where an FPC is electrically connected to the mainboard by using a board-to-board connector (Board-to-Board Connector, BTB) or a zero insertion force connector (Zero Insertion Force connector, ZIF). However, both the BTB connector and the ZIF connector require a press-fitting structure to fasten the FPC, resulting in large space occupied inside the electronic device. This is not conducive to miniaturization of the electronic device.

### SUMMARY

This application provides an electrical connector, a circuit board assembly, and an electronic device.

According to a first aspect, an embodiment of this application provides an electrical connector. The electrical connector is configured for an electrical connection between a circuit board and a signal transmission structure. The electrical connector includes an insulation housing and a terminal. The terminal is fastened to the insulation housing. An insertion space is provided inside the insulation housing. An opening is provided in a bottom surface of the insulation housing, and the opening communicates the insertion space and an outside of the insulation housing. The bottom surface of the insulation housing faces the circuit board. A first electrical connection end of the terminal is at least partially located in the insertion space and is configured to be electrically connected to the signal transmission structure. A second electrical connection end of the terminal extends out of the bottom surface of the insulation housing and is configured to be electrically connected to the circuit board. When the electrical connector is configured to be electrically connected to the signal transmission structure, the signal transmission structure enters the insertion space through the opening and is connected to the first electrical connection end of the terminal.

It may be understood that, according to the electrical connector in this application, the first electrical connection end and the second electrical connection end of the terminal are electrically connected to the signal transmission structure and the circuit board on a side of the bottom surface of the electrical connector. In this way, the signal transmission structure can be fastened through cooperation between the circuit board and a surrounding structure. Therefore, compared with a ZIF connector or a BTB connector, the electrical connector provided in this application may not require an additional press-fitting structure to fasten the signal transmission structure, thereby effectively reducing a volume of the electrical connector, and reducing costs.

In a possible implementation, the terminal includes a first terminal and a second terminal, and a part of the first electrical connection end of the first terminal and a part of a third electrical connection end of the second terminal are located on two sides of the insertion space. When a first insertion end of the signal transmission structure is inserted into the insertion space, the first electrical connection end of the first terminal and the third electrical connection end of the second terminal are respectively connected to two sides of the signal transmission structure.

It may be understood that, based on the technical solution in which the terminal includes the first terminal and the second terminal, double-sided signal output can be implemented at the first insertion end of the signal transmission structure. When a quantity of terminals remains unchanged, compared with a solution of single-sided signal output, this technical solution can effectively reduce a volume of the electrical connector, thereby facilitating miniaturization of the electronic device. In addition, the solution of double-row terminals can be compatible with both a signal transmission structure for single-sided signal output and a signal transmission structure for double-sided signal output, making an application scenario of the electrical connector less limited. When the signal transmission structure implements double-sided signal output, contact regions are provided on two sides of the first insertion end, and the first electrical connection end of the first terminal and the third electrical connection end of the second terminal are respectively connected to the contact regions on the two sides of the first insertion end.

In a possible implementation, the insulation housing is further provided with a first movement space, the first movement space is in communication with the insertion space and is located on a side of the insertion space, the first terminal is partially located in the first movement space, the first terminal is further configured to abut against the first insertion end of the signal transmission structure when the first insertion end of the signal transmission structure is inserted into the insertion space, and the first movement space is provided to provide space for deformation of the first terminal when the first terminal abuts against the first insertion end of the signal transmission structure; and/or
the insulation housing is further provided with a second movement space, the second movement space is in communication with the insertion space and is located on a side that is of the insertion space and that is away from the first movement space, the second terminal is at least partially located in the second movement space, the second terminal is further configured to abut against the first insertion end of the signal transmission structure when the first insertion end of the signal transmission structure is inserted into the insertion space, and the second movement space is provided to provide space for deformation of the second terminal when the second terminal abuts against the first insertion end of the signal transmission structure.

It may be understood that the first movement space is provided to provide space for deformation of the first electrical connection end of the first terminal when the first terminal abuts against the first insertion end of the signal transmission structure. The second movement space is provided to provide space for deformation of the third electrical connection end of the second terminal when the second terminal abuts against the first insertion end of the signal transmission structure.

In a possible implementation, the first electrical connection end of the first terminal is located on a side that is of the insertion space and that is away from the second electrical connection end of the first terminal; and/or
the third electrical connection end of the second terminal is located on a side that is of the insertion space and that is away from the fourth electrical connection end of the second terminal.

It may be understood that, compared with the first electrical connection end of the first terminal and the second electrical connection end of the first terminal being located on a same side of the first insertion end, the first electrical connection end of the first terminal and the second electrical connection end of the first terminal are respectively located on two sides of the first insertion end. When the first terminal abuts against the first insertion end of the signal transmission structure, deformation of the first terminal can be evenly distributed to all positions of the first terminal, and a deformation force is evenly applied to the first terminal, resulting in a long service life of the first terminal and good reliability of the electrical connection between the electrical connector and the signal transmission structure.

Similar to the configuration of the first terminal, the third electrical connection end of the second terminal may also be located on the side that is of the insertion space and that is away from the second electrical connection end of the second terminal. The second terminal may be partially located in the first movement space and partially located in the second movement space opposite to the first movement space. In this way, a deformation force is evenly applied to all positions of the second terminal, resulting in a long service life of the second terminal and good electrical connection reliability of the electrical connector.

In a possible implementation, there are a plurality of first terminals, the plurality of first terminals are spaced apart in an extension direction of the insertion space, there are a plurality of second terminals, and the plurality of second terminals are spaced apart in the extension direction of the insertion space. The plurality of first terminals and the plurality of second terminals are arranged alternately in the extension direction of the insertion space.

It may be understood that the alternate arrangement of the plurality of first terminals and the plurality of second terminals results in compact signal transmission.

In a possible implementation, the first electrical connection end of the first terminal and the second electrical connection end of the first terminal are located on a same side of the insertion space; and/or
the third electrical connection end of the second terminal and a fourth electrical connection end of the second terminal are located on a same side of the insertion space.

It may be understood that the first terminal and the second terminal are respectively located on two sides of the insertion space. When the signal transmission structure enters the insertion space, the first terminal and the second terminal can be respectively located on two sides of the signal transmission structure.

In a possible implementation, the first electrical connection end of the first terminal and the third electrical connection end of the second terminal are opposite to each other.

In a possible implementation, a projection of the first electrical connection end of the first terminal on a reference plane and a projection of the third electrical connection end of the second terminal on the reference plane partially overlap in the extension direction of the insertion space, and the reference plane is perpendicular to the extension direction of the insertion space.

It may be understood that the projection of the first electrical connection end of the first terminal on the reference plane and the projection of the third electrical connection end of the second terminal on the reference plane partially overlap in the extension direction of the insertion space, helping reduce a volume of the electrical connector, and facilitating miniaturization of the electronic device.

In a possible implementation, the first electrical connection end of the terminal is in a "V" shape, a "U" shape, an "S" shape, a wavy shape, or a paperclip shape.

In a possible implementation, the insulation housing includes a positioning structure, and the positioning structure is a through hole or a groove.

It may be understood that the positioning structure can be configured to assist in positioning during mounting of the circuit board assembly, improving mounting efficiency.

In a possible implementation, the electrical connector further includes a reinforcement member made of a metal material, the reinforcement member is fastened to the insulation housing, and the reinforcement member is configured to enhance connection strength between the electrical connector and the circuit board.

It may be understood that reliability of a connection between the electrical connector and the circuit board can be enhanced by disposing the reinforcement member, thereby improving reliability of an electrical connection between the electrical connector and the signal transmission structure.

According to a second aspect, an embodiment of this application provides a circuit board assembly. The circuit board assembly includes a circuit board and an electrical connector, and the electrical connector is fastened to the circuit board.

It may be understood that, according to the electrical connector, the first electrical connection end and the second electrical connection end of the terminal are electrically connected to the signal transmission structure and the circuit board on a side of the bottom surface of the electrical connector. In this way, the signal transmission structure can be fastened through cooperation between the circuit board and the insulation housing of the electrical connector. Therefore, compared with a ZIF connector or a BTB connector, the electrical connector provided in this application may not require an additional press-fitting structure to fasten the signal transmission structure, thereby effectively reducing a volume of the electrical connector, and also making the circuit board assembly small in volume.

In a possible implementation, the circuit board is provided with a first through hole, and the first through hole and the electrical connector are opposite to each other.

It may be understood that the first insertion end of the signal transmission structure can pass through the circuit board through the first through hole and be electrically connected to the terminal. In this way, the signal transmission structure can be arranged between the circuit board and an outer shell (as shown in the figure). The electrical connector is fastened to a surface of a side that is of the circuit board and that is away from the outer shell. The signal transmission structure may be partially located between the circuit board and the outer shell. The circuit board and the outer shell cooperate to abut against the signal transmission structure, so that the signal transmission structure is fastened.

According to a third aspect, an embodiment of this application provides an electronic device. The electronic device includes an outer shell and a circuit board assembly, where the circuit board assembly is mounted in the outer shell.

It may be understood that the circuit board assembly is mounted in the outer shell, and the signal transmission structure may be arranged between a circuit board and the outer shell. The electrical connector is fastened to a surface of a side that is of the circuit board and that is away from the outer shell. The signal transmission structure may be partially located between the circuit board and the outer shell. The circuit board and the outer shell cooperate to abut against the signal transmission structure, so that the signal transmission structure is fastened.

In addition, compared with a solution in which the signal transmission structure is connected from a top surface or a side surface of the electrical connector, the solution in which the signal transmission structure is connected from a bottom surface of the electrical connector can allow the signal transmission structure to be disposed close to the circuit board, and allow arrangement of the signal transmission structure to be more compact, facilitating miniaturization of the electronic device.

### BRIEF DESCRIPTION OF DRAWINGS

To describe technical solutions in embodiments of this application, the following describes accompanying drawings used in embodiments of this application.
FIG. 1 is a cross-sectional view of an electronic device in an implementation according to an embodiment of this application;
FIG. 2 is a cross-sectional view of the electronic device shown in FIG. 1 at A-A in an implementation;
FIG. 3a is a diagram of assembly of some structures of an electrical connector, a signal transmission structure, and a circuit board shown in FIG. 2 in an implementation;
FIG. 3b is an exploded view of the structures shown in FIG. 3a in an implementation;
FIG. 4a is an exploded view of the electrical connector shown in FIG. 3b in an implementation;
FIG. 4b is a diagram of a structure of an insulation housing shown in FIG. 4a from another angle;
FIG. 4c is a diagram of the electrical connector shown in FIG. 3a from another angle;
FIG. 5 is a partial cross-sectional view of the structures shown in FIG. 3a at a section line B-B in an implementation;
FIG. 6 is a partial cross-sectional view of the structures shown in FIG. 3a at a section line C-C in an implementation;
FIG. 7 is a cross-sectional view of the electrical connector shown in FIG. 4c at a section line D-D from another angle in an implementation;
FIG. 8 is a partial cross-sectional view of the structures shown in FIG. 3a at a section line E-E in an implementation;
FIG. 9 is a partial cross-sectional view of the structures shown in FIG. 3a at a section line F-F in an implementation;
FIG. 10 is a diagram of a structure of the electrical connector shown in FIG. 2 in another implementation; and
FIG. 11 is a cross-sectional view of the electrical connector shown in FIG. 10 at a section line G-G from another angle in an implementation.

### DESCRIPTION OF EMBODIMENTS

In descriptions of embodiments of this application, it needs to be noted that, unless otherwise clearly specified and limited, terms "mounting" and "connection" should be understood in a broad sense. For example, the "connection" may be a detachable connection, an undetachable connection, a direct connection, or an indirect connection through an intermediate medium. A "fixed connection" means a connection to each other with an unchanged relative position relationship. It should be understood that a fixed connection between a component A and a component C by a component B allows a change in a relative position relationship caused by deformation of the component A, the component B, and the component C. A "rotatable connection" means a connection to each other in a relatively rotatable manner. A "slidable connection" means a connection to each other in a relatively slidable manner. Integrating two components into an integrated structure by using an integrated molding process means that, in a process of forming one of the two components, the component is connected to the other component, without requiring subsequent processing (such as bonding, welding, snap-fit connections, or screw connections) to connect the two components together. In this application, that a component A and a component B are opposite to each other may be that the component A is projected in a target direction to obtain a projection C, the component B is projected in the target direction to obtain a projection D, and the projection C and the projection D may at least partially overlap. That a component A and a component B are staggered may be that the component A is projected in a target direction to obtain a projection C, the component B is projected in the target direction to obtain a projection D, and the projection C and the projection D do not overlap at all.

Orientation terms mentioned in embodiments of this application, such as "upper", "lower", "side surface", "top", and "bottom", are merely directions in the accompanying drawings. Therefore, the orientation terms are used to better and more clearly describe and understand embodiments of this application, instead of indicating or implying that a specified apparatus or element needs to have a specific orientation or needs to be constructed and operated in a specific orientation. Therefore, this cannot be understood as a limitation on embodiments of this application.

The term "plurality of" means at least two. The term "above" includes a present number. The term "and/or" describes an association relationship between associated objects and indicates that three relationships may exist. For example, A and/or B may indicate the following three cases: Only A exists, both A and B exist, and only B exists. Terms such as "first" and "second" are used only for description purposes, and cannot be understood as an indication or implication of relative importance or an implicit indication of a quantity of indicated technical features. Therefore, a feature limited by "first" or "second" may explicitly or implicitly include one or more features. The following describes embodiments of this application with reference to the accompanying drawings in embodiments of this application.

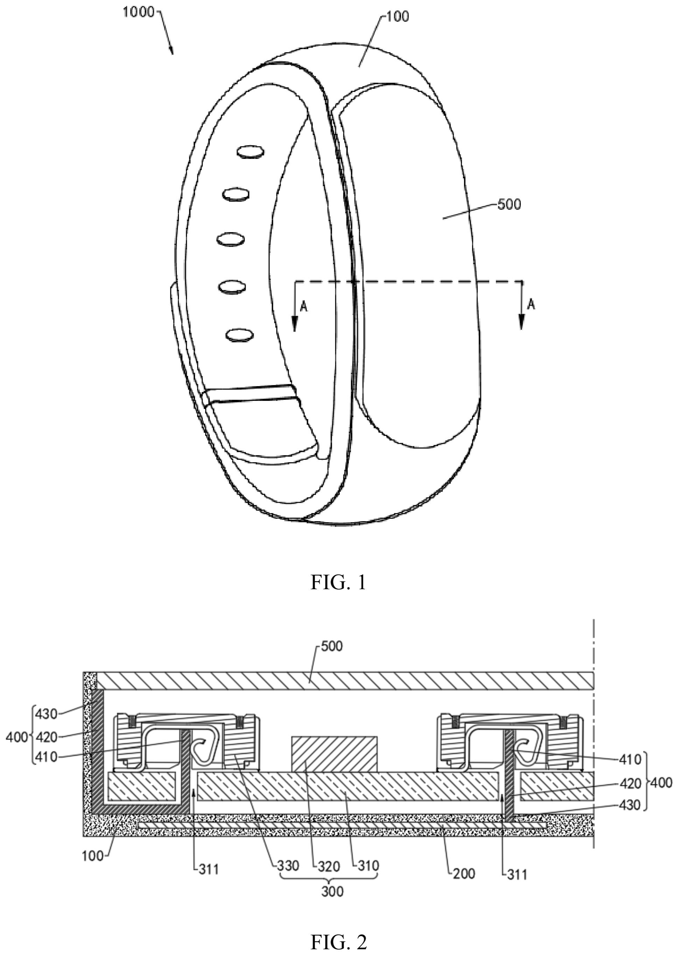

FIG. 1 is a diagram of a structure of an electronic device 1000 in an implementation according to an embodiment of this application.

The electronic device 1000 may be a small terminal wearable device such as a smartwatch, a smart band, a smart headset, augmented reality (augmented reality, AR) glasses, virtual reality (virtual reality, VR) glasses, mixed reality (Mixed Reality, MR) glasses, a VR helmet, an AR helmet, or an MR helmet. Alternatively, the electronic device 1000 may be a mobile phone, a tablet computer, a notebook computer, a handheld computer, a walkie-talkie, a POS machine, a personal digital assistant (personal digital assistant, PDA), or the like. An example in which the electronic device 1000 shown in FIG. 1 is a smart band is used for description.

FIG. 2 is a cross-sectional view of the electronic device 1000 shown in FIG. 1 at A-A in an implementation.

As shown in FIG. 1 and FIG. 2, the electronic device 1000 may include an outer shell 100, an electronic component 200, a circuit board assembly 300, and a signal transmission structure 400. The outer shell 100 encloses an internal space of the electronic device 1000. Both the circuit board assembly 300 and the signal transmission structure 400 may be mounted in the internal space of the electronic device 1000, that is, in the outer shell 100.

The outer shell 100 may be made of a metal material, or may be made of a glass material, or may be made of a plastic material, or may be made of a ceramic material.

The electronic component 200 may include, but is not limited to, a wireless charging coil, a battery, a sensor, a processor, an internal memory, an interface for external memory, a universal serial bus (universal serial bus, USB) interface, a charging management module, a power management module, a battery, an antenna, a communication module, a camera, an audio module, a speaker, a receiver, a microphone, a headset jack, a sensor module, a button, a motor, an indicator, or another component that needs to be electrically connected to the circuit board assembly 300. The electronic component 200 may be insert-molded inside the outer shell 100, or may be exposed out of the outer shell 100, or may be mounted in the internal space of the electronic device 1000. Different electronic components 200 may be disposed at different positions according to actual requirements. For example, when the electronic device 1000 is a smart band, a wireless charging coil of the smart band may be insert-molded into the outer shell 100, and a communication module and another electronic component (not shown in the figure) may be mounted in the internal space of the electronic device 1000.

In some implementations, when the electronic device 1000 has a display function, the electronic component 200 may further include a screen 500. The screen 500 is mounted on the outer shell 100. In this case, the screen 500 and the outer shell 100 can jointly enclose the internal space of the electronic device 1000. The screen 500 may be configured to display an image, a video, and the like. In some implementations, the screen 500 may further have a touch sensing function, and the touch sensing function of the screen 500 is for sensing a touch action of a user, to implement human-computer interaction. For example, the screen 500 may be a liquid crystal display (liquid crystal display, LCD), an organic light-emitting diode (organic light-emitting diode, OLED) display, a flexible light-emitting diode (flexible light-emitting diode, FLED) display, a mini-LED display, a micro-LED display, a micro-OLED display, a quantum dot light-emitting diode (quantum dot light-emitting diode, QLED) display, or the like.

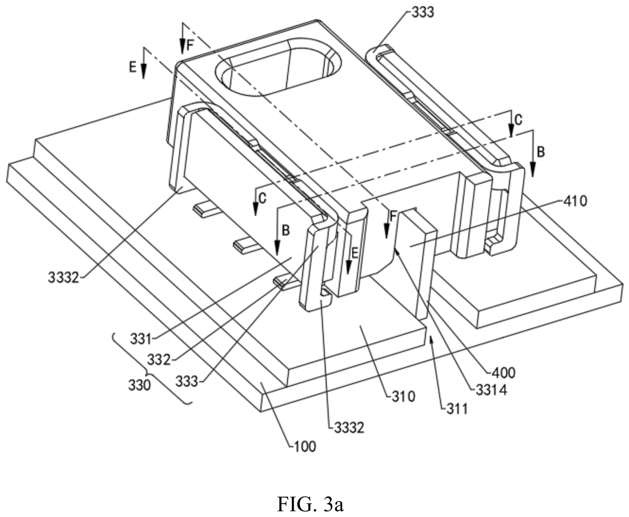

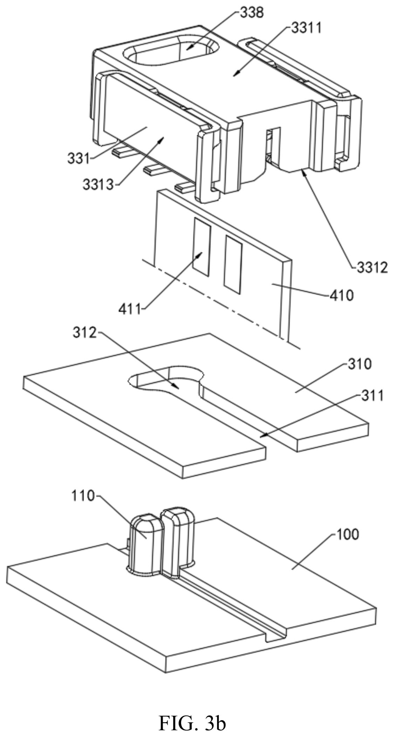

FIG. 3a is a diagram of assembly of some structures of an electrical connector 330, a signal transmission structure 400, and a circuit board 310 shown in FIG. 2 in an implementation. FIG. 3b is an exploded view of the structures shown in FIG. 3a in an implementation.

As shown in FIG. 2, FIG. 3a, and FIG. 3b, the circuit board assembly 300 may include a circuit board 310, an electronic element 320, and an electrical connector 330. Both the electronic element 320 and the electrical connector 330 are fastened to the circuit board 310. The electronic element 320 and the electrical connector 330 are spaced apart. The electrical connector 330 may be electrically connected to the electronic element 320 by the circuit board 310. For example, the electronic element 320 may be an active component such as a chip, or may be a passive component such as a capacitor, an inductor, or a resistor. It may be understood that a person skilled in the art can select a type of the electronic element 320 and a way to connect the electronic element 320 to the circuit board 310, so that the circuit board assembly 300 with a specific function, for example, a mainboard of the electronic device 1000, can be obtained. The electrical connector 330 is configured to transfer a signal from the signal transmission structure 400 to the circuit board 310. A specific structure of the electrical connector 330 is specifically described below with reference to the accompanying drawings, and details are not described herein again.

The signal transmission structure 400 is configured to transmit a signal from the electronic component 200 to the circuit board assembly 300, or transmit a signal from the circuit board assembly 300 to the electronic component 200. In this way, a signal from the electronic component 200 can pass through the signal transmission structure 400, the electrical connector 330, and the circuit board 310, and finally arrive at the electronic element 320 on the circuit board 310. An electrical signal from the electronic element 320 can sequentially pass through the circuit board 310, the electrical connector 330, and the signal transmission structure 400, and finally arrive at the electronic component 200. For example, the signal transmission structure 400 may include a first insertion end 410, a transmission section 420, and a second insertion end 430. The transmission section 420 is connected between the first insertion end 410 and the second insertion end 430. The first insertion end 410 is configured to be electrically connected to the electrical connector 330. The second insertion end 430 is configured to be electrically connected to the electronic component 200.

The signal transmission structure 400 may be a flexible cable structure such as an FPC or an FFC, or the signal transmission structure 400 may be a rigid structure such as injection-molded edge connector tongues or a PCB board. The first insertion end 410 may include a contact region 411. The contact region may be an exposed region of a metal conducting wire inside the signal transmission structure 400, and is configured to implement an electrical connection to the electronic component 200 or the electrical connector 330. In some implementations, the second insertion end 430 may also include a contact region (not shown in the figure).

There may be one or more signal transmission structures 400 included in the electronic device 1000. One circuit board assembly 300 may include one or more electrical connectors 330. For example, a quantity of electrical connectors 330 may be equal to a quantity of signal transmission structures 400. A plurality of signal transmission structures 400 are connected to a plurality of electrical connectors 330 in a one-to-one correspondence. When there are a plurality of signal transmission structures 400, the plurality of signal transmission structures 400 may be used for signal transmission between different electronic components 200 and the circuit board assembly 300. In addition, the electronic device 1000 may include one or more circuit board assemblies 300. A plurality of circuit board assemblies 300 may be provided with electrical connectors 330. A plurality of signal transmission structures 400 may be respectively connected to different circuit board assemblies 300.

For example, FIG. 2 shows two signal transmission structures 400 and two electrical connectors 330. A first insertion end 410 of the first signal transmission structure 400 is connected to the first electrical connector 330, and a second insertion end 430 is connected to the screen 500. A first insertion end 410 of the second signal transmission structure 400 is connected to the second electrical connector 330, and a second insertion end 430 is connected to a wireless charging coil in the outer shell 100.

The circuit board 310 may be fastened to an inner surface of the outer shell 100 of the electronic device 1000, and the inner surface of the outer shell 100 faces the internal space of the electronic device 1000. For example, the circuit board 310 may be fastened to the outer shell 100 by adhesive bonding or snap fitting, using screws, or in another manner. In another implementation, the circuit board 310 may be fastened to another structural component inside the electronic device 1000.

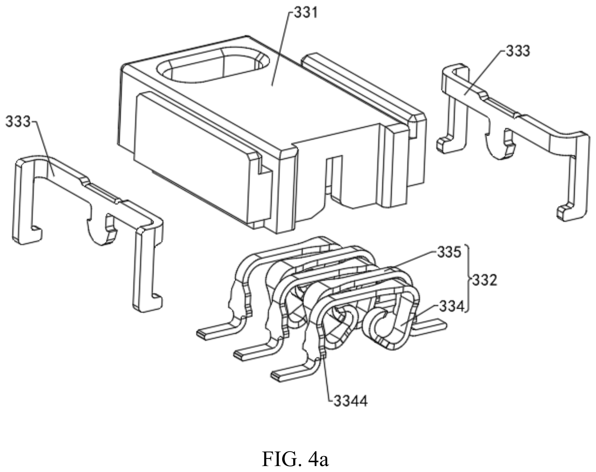

FIG. 4a is an exploded view of the electrical connector 330 shown in FIG. 3b in an implementation.

As shown in FIG. 3b and FIG. 4a, the electrical connector 330 includes an insulation housing 331, a terminal 332, and a reinforcement member 333. The insulation housing 331 includes a top surface 3311, a bottom surface 3312, and a side surface 3313. The top surface 3311 and the bottom surface 3312 face away from each other, and the side surface 3313 is connected between the top surface 3311 and the bottom surface 3312. The bottom surface 3312 faces the circuit board 310. The insulation housing 331 is made of an insulation material. For example, the insulation housing 331 may be made of plastic and formed by an injection molding process.

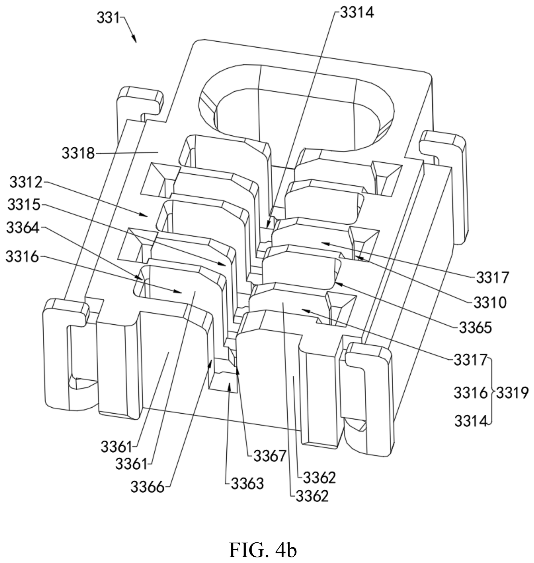

FIG. 4b is a diagram of a structure of the insulation housing 331 shown in FIG. 4a from another angle.

As shown in FIG. 4b, the insulation housing 331 may include a housing body 3318 and a baffle plate. The housing body 3318 is provided with an accommodation groove 3319, and an opening of the accommodation groove 3319 is located in a bottom surface of the housing body 3318. It may be understood that the bottom surface of the housing body 3318 is a part of the bottom surface 3312 of the insulation housing, or the bottom surface of the housing body 3318 is the bottom surface 3312 of the insulation housing 331, and the opening of the accommodation groove 3319 is located in the bottom surface 3312 of the insulation housing 331. When the electrical connector 330 is fastened to the circuit board 310, the opening of the accommodation groove 3319 faces the circuit board 310. The baffle plate is fastened to a bottom wall 3363 and a side wall of the accommodation groove 3319.

For example, the side wall of the accommodation groove 3319 includes a first side wall 3364 and a second side wall 3365 that are opposite to each other. The baffle plate includes a first baffle plate 3361 and a second baffle plate 3362 that are opposite to each other and that are spaced apart. The first baffle plate 3361 is fastened to the bottom surface and the first side wall 3364 of the accommodation groove 3319. The second baffle plate 3362 is fastened to the bottom wall 3363 and the second side wall 3365 of the accommodation groove 3319. The first baffle plate 3361 includes a first side surface 3366 facing the second baffle plate 3362, and the second baffle plate 3362 includes a second side surface 3367 facing the first baffle plate 3361. An insertion space 3314 is enclosed by the first side surface 3366, the second side surface 3367, and the bottom wall 3363 of the accommodation groove 3319. An opening 3315 is provided in the bottom surface 3312 of the insulation housing 331, and the opening 3315 is in communication with the insertion space 3314.

There are a plurality of first baffle plates 3361 and a plurality of second baffle plates 3362, and a quantity of first baffle plates 3361 is equal to a quantity of second baffle plates 3362. The plurality of first baffle plates 3361 are spaced apart in a first direction, and the plurality of second baffle plates 3362 are also spaced apart in the first direction. The plurality of first baffle plates 3361 and the plurality of second baffle plates 3362 are opposite to each other in a one-to-one correspondence. For example, the insulation housing 331 shown in FIG. 4b includes six first baffle plates 3361 and six second baffle plates 3362.

A first movement space 3316 is enclosed by two adjacent first baffle plates 3361, and the bottom wall 3363 and the first side wall 3364 of the accommodation groove 3319. The first movement space 3316 is in communication with the insertion space 3314 and is located on a side of the insertion space 3314. A second movement space 3317 is enclosed by two adjacent second baffle plates 3362, and the bottom wall 3363 and the second side wall 3365 of the accommodation groove 3319. The second movement space 3317 is in communication with the insertion space 3314 and is located on a side that is of the insertion space 3314 and that is away from the first movement space 3316. The first movement space 3316 and the second movement space 3317 are located on two sides of the insertion space 3314. It may be understood that the first baffle plate 3361 and the second baffle plate 3362 are configured to divide the accommodation groove 3319 into the insertion space 3314, the first movement space 3316, and the second movement space 3317.

There may be one or more first movement spaces 3316. There may be one or more second movement spaces 3317. For example, the insulation housing 331 shown in FIG. 4b includes five first movement spaces 3316 and five second movement spaces.

In some implementations, the housing body 3318 and the baffle plate may be an integrally formed structural component. For example, the insulation housing 331 may be an integrated structural component formed by an injection molding process.

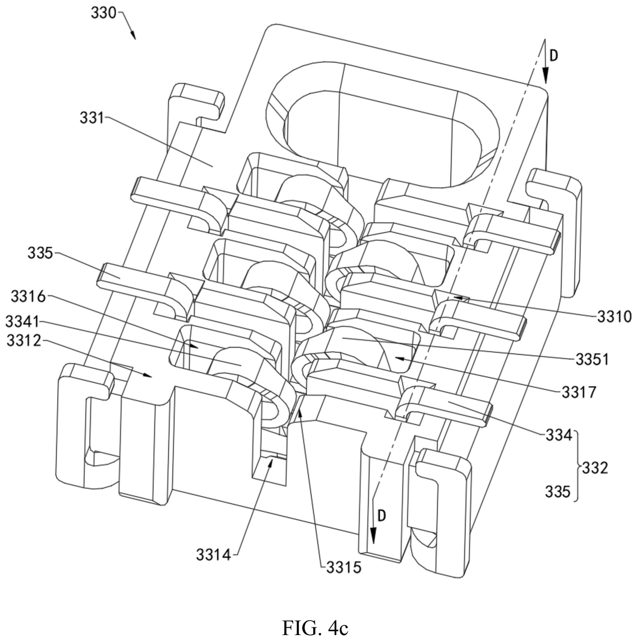

FIG. 4c is a diagram of the electrical connector 330 shown in FIG. 3a from another angle.

As shown in FIG. 3a and FIG. 4c, the terminal 332 is configured to electrically connect the signal transmission structure 400 and the circuit board 310. The terminal 332 may be configured to transmit the signal transmission structure 400 to the circuit board 310, or transmit a signal from the circuit board 310 to the signal transmission structure 400. The terminal 332 is fastened to the insulation housing 331. It may be understood that the terminal 332 may be fastened to the insulation housing 331 by snap fitting, adhesive bonding, or the like, or the terminal 332 may be insert-molded into the insulation housing 331. For example, the terminal 332 and the insulation housing 331 may be an integrated structural component formed by an insert molding process. The insert molding (insert molding) process is a molding process in which a prepared insert is placed in a mold and then a molten material is injected, for the molten material and the insert to be bonded and solidified, to obtain an integrated product.

For example, the terminal 332 may include a first electrical connection end electrically connected to the signal transmission structure 400 and a second electrical connection end electrically connected to the circuit board 310.

In some implementations, the insertion space 3314 of the insulation housing 331 may be provided to accommodate the first insertion end 410 of the signal transmission structure 400. It may be understood that the insertion space 3314 can limit the first insertion end 410 of the signal transmission structure 400, so that the signal transmission structure 400 is unlikely to wobble. The first electrical connection end of the terminal 332 is at least partially located in the insertion space 3314 and is configured to be electrically connected to the first insertion end 410 of the signal transmission structure 400.

For example, the opening 3315 is located in the bottom surface 3312 of the insulation housing 331. The opening 3315 communicates the insertion space 3314 and an external space of the insulation housing 331. When the electrical connector 330 is electrically connected to the signal transmission structure 400, the first insertion end 410 of the signal transmission structure 400 may enter the insertion space 3314 through the opening 3315, be connected to the first electrical connection end of the terminal 332, and be electrically connected to the first electrical connection end of the terminal 332. It needs to be noted that, when the electrical connector 330 is mounted in the internal space of the electronic device, the external space of the insulation housing 331 may be the internal space of the electronic device. When the electrical connector 330 is exposed out of the electronic device, the outside may be an external environment in which the electronic device is located. The communication may be direct communication or may be indirect communication.

In some implementations, in a thickness direction of the electrical connector 330 (that is, a direction in which the bottom surface 3312 faces the top surface 3311 of the electrical connector 330), the opening 3315 may be opposite to the insertion space 3314 (as shown in FIG. 4c). In this case, the opening 3315 may be in direct communication with the insertion space 3314. The first electrical connection end of the terminal 332 may be exposed out of the opening 3315 of the bottom surface 3312.

In another implementation, in the thickness direction of the electrical connector 330, the opening 3315 and the insertion space 3314 may be staggered. In this case, the opening 3315 may be in indirect communication with the insertion space 3314. For example, the insulation housing 331 may be provided with a connection channel. One end of the connection channel is in communication with the opening 3315, and the other end is in communication with the insertion space 3314. The opening 3315 may be in indirect communication with the insertion space 3314 through the connection channel. The first insertion end 410 of the signal transmission structure 400 may enter the insertion space 3314 through the opening 3315 and the connection channel, and be connected to the first electrical connection end of the terminal 332.

The second electrical connection end of the terminal 332 extends out of the bottom surface 3312 of the insulation housing 331 and is electrically connected to the circuit board 310. For example, the second electrical connection end of the terminal 332 may also extend out of the insulation housing 331 through the opening 3315 and be connected to the circuit board 310, to implement an electrical connection to the circuit board 310. In some implementations, the second electrical connection end of the terminal 332 may be electrically connected to the circuit board 310 by welding.

It may be understood that, as shown in FIG. 2, FIG. 3a, and FIG. 4c, according to the electrical connector 330 in this application, the first electrical connection end and the second electrical connection end of the terminal 332 are electrically connected to the signal transmission structure 400 and the circuit board 310 on a side of the bottom surface 3312 of the electrical connector 330. In this way, the signal transmission structure 400 can be fastened through cooperation between the circuit board 310 and a surrounding structure. Therefore, compared with a ZIF connector or a BTB connector, the electrical connector 330 provided in this application may not require an additional press-fitting structure to fasten the signal transmission structure 400, thereby effectively reducing a volume of the electrical connector 330, facilitating miniaturization of the electronic device 1000, and reducing costs. In addition, compared with a solution in which the signal transmission structure 400 is connected from a top surface 3311 or a side surface 3313 of the electrical connector 330, the solution in which the signal transmission structure 400 is connected from a bottom surface 3312 of the electrical connector 330 can allow the signal transmission structure 400 to be disposed close to the circuit board 310, and allow arrangement of the signal transmission structure 400 to be more compact, facilitating miniaturization of the electronic device 1000.

For example, the signal transmission structure 400 can be arranged between the circuit board 310 and the outer shell 100 (as shown in FIG. 2). The electrical connector 330 is fastened to a surface of a side that is of the circuit board 310 and that is away from the outer shell 100. The signal transmission structure 400 may be partially located between the circuit board 310 and the outer shell 100. The circuit board 310 and the outer shell 100 cooperate to abut against the signal transmission structure 400, so that the signal transmission structure 400 is fastened. For example, the circuit board 310 may be provided with a first through hole 311, and the first through hole 311 and the bottom surface 3312 of the electrical connector 330 are opposite to each other. The first insertion end 410 of the signal transmission structure 400 can pass through the circuit board 310 through the first through hole 311 and be electrically connected to the terminal 332.

As shown in FIG. 3a and FIG. 4c, the terminal 332 may include a first terminal 334 and a second terminal 335. The first terminal 334 may include a first electrical connection end 3341 electrically connected to the signal transmission structure 400 and a second electrical connection end 3342 electrically connected to the circuit board 310. The second terminal 335 may also include a third electrical connection end 3351 electrically connected to the signal transmission structure 400 and a fourth electrical connection end 3352 electrically connected to the circuit board 310. A part of the first electrical connection end 3341 of the first terminal 334 and a part of the third electrical connection end 3351 of the second terminal 335 are opposite to each other. The part of the first electrical connection end 3341 of the first terminal 334 and the part of the third electrical connection end 3351 of the second terminal 335 are located in the insertion space 3314 and are configured to be electrically connected to the first insertion end 410 of the signal transmission structure 400. When the first insertion end 410 is inserted into the insertion space 3314, the first electrical connection end 3341 of the first terminal 334 and the third electrical connection end 3351 of the second terminal 335 may be respectively connected to two sides of the first insertion end 410.

It may be understood that, based on the technical solution in which the terminal 332 includes the first terminal 334 and the second terminal 335, double-sided signal output can be implemented at the first insertion end 410 of the signal transmission structure 400. When a quantity of terminals 332 remains unchanged, compared with a solution of single-sided signal output, this technical solution can effectively reduce a volume of the electrical connector 330, thereby facilitating miniaturization of the electronic device 1000. In addition, the solution of double-row terminals 332 can be compatible with both a signal transmission structure 400 for single-sided signal output and a signal transmission structure 400 for double-sided signal output, making an application scenario of the electrical connector 330 less limited. When the signal transmission structure 400 implements double-sided signal output, contact regions are provided on two sides of the first insertion end 410, and the first electrical connection end 3341 of the first terminal 334 and the third electrical connection end 3351 of the second terminal 335 are respectively connected to the contact regions on the two sides of the first insertion end 410.

In another implementation, the signal transmission structure 400 may be arranged between the circuit board 310 and the electrical connector 330 (not shown in the figure). In this case, the signal transmission structure 400 is partially located between the insulation housing 331 of the electrical connector 330 and the circuit board 310, and the electrical connector 330 and the circuit board 310 can cooperate to abut against the signal transmission structure 400, so that the signal transmission structure 400 is fastened. It may be understood that, compared with the solution in which the signal transmission structure 400 is arranged between the circuit board 310 and the electrical connector 330, the solution in which the signal transmission structure 400 is arranged between the circuit board 310 and the outer shell 100 requires no avoidance of the signal transmission structure 400 on a side that is of the circuit board 310 and that is away from the outer shell 100. In a case that a quantity of electronic elements 320 on the circuit board 310 is unchanged, an area of the circuit board 310 can be reduced, thereby facilitating miniaturization of the electronic device 1000. In addition, a region that is on the circuit board 310 and that is originally for avoiding the signal transmission structure 400 can be used for disposing an electronic element 320, so that more functional elements can be disposed in limited space, facilitating multifunctionality of the electronic device 1000.

In another implementation, when the circuit board 310 is mounted on another structural component inside the electronic device 1000, the signal transmission structure 400 may be arranged between the circuit board 310 and a housing of the structural component.

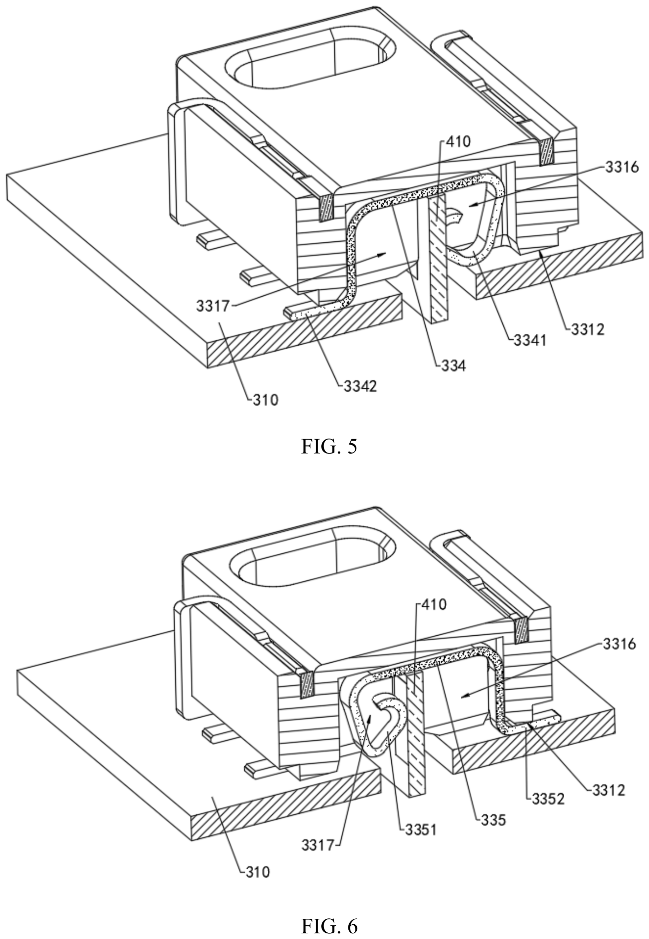

FIG. 5 is a partial cross-sectional view of the structures shown in FIG. 3a at a section line B-B in an implementation.

As shown in FIG. 5, the first electrical connection end 3341 of the first terminal 334 may be a metal spring. When the first terminal 334 is connected to the signal transmission structure 400, the first electrical connection end 3341 of the first terminal 334 may abut against the first insertion end 410 of the signal transmission structure 400. In this way, a risk of movement of the signal transmission structure 400 can be reduced, resulting in good reliability of an electrical connection between the first terminal 334 and the signal transmission structure 400. For example, the first electrical connection end 3341 of the first terminal 334 may be in a "V" shape, a "U" shape, an "S" shape, a wavy shape, or a paperclip shape.

For example, when the first terminal 334 abuts against the first insertion end 410 of the signal transmission structure 400, the first electrical connection end 3341 of the first terminal 334 deforms. A part of the first electrical connection end 3341 of the first terminal 334 may be located in the first movement space 3316. The first movement space 3316 is provided to provide space for deformation of the first electrical connection end 3341 of the first terminal 334 when the first terminal 334 abuts against the first insertion end 410 of the signal transmission structure 400. In another implementation, the insulation housing 331 may not be provided with the first movement space 3316, and the part that is of the first terminal 334 and that is located in the first movement space 3316 may be insert-molded into the insulation housing 331.

For example, the first electrical connection end 3341 of the first terminal 334 may be located on a side that is of the insertion space 3314 and that is away from the second electrical connection end 3342 of the first terminal 334. When the first insertion end 410 of the signal transmission structure 400 is inserted into the insertion space 3314, the first electrical connection end 3341 of the first terminal 334 and the second electrical connection end 3342 of the first terminal 334 are respectively located on two sides of the first insertion end 410. The first terminal 334 may be partially located in the first movement space 3316 and partially located in the second movement space 3317 opposite to the first movement space 3316.

It may be understood that, compared with the first electrical connection end 3341 of the first terminal 334 and the second electrical connection end 3342 of the first terminal 334 being located on a same side of the first insertion end 410, the first electrical connection end 3341 of the first terminal 334 and the second electrical connection end 3342 of the first terminal 334 are respectively located on two sides of the first insertion end 410. When the first terminal 334 abuts against the first insertion end 410 of the signal transmission structure 400, deformation of the first terminal 334 can be evenly distributed to all positions of the first terminal 334, and a deformation force is evenly applied to the first terminal 334, resulting in a long service life of the first terminal 334 and good reliability of the electrical connection between the electrical connector 330 and the signal transmission structure 400.

FIG. 6 is a partial cross-sectional view of the structures shown in FIG. 3a at a section line C-C in an implementation.

As shown in FIG. 6, the third electrical connection end 3351 of the second terminal 335 may also be a metal spring. When the second terminal 335 is connected to the signal transmission structure 400, the third electrical connection end 3351 of the second terminal 335 may abut against the first insertion end 410 of the signal transmission structure 400. In this way, a risk of movement of the signal transmission structure 400 can be further reduced, resulting in good reliability of an electrical connection between the second terminal 335 and the signal transmission structure 400. For example, the third electrical connection end 3351 of the second terminal 335 may be in a "V" shape or a "U" shape. The electrical connection ends may be in a same shape or in different shapes.

For example, when the second terminal 335 abuts against the first insertion end 410 of the signal transmission structure 400, the third electrical connection end 3351 of the second terminal 335 deforms. A part of the third electrical connection end 3351 of the second terminal 335 may be located in the second movement space 3317. The second movement space 3317 is provided to provide space for deformation of the third electrical connection end 3351 of the second terminal 335 when the second terminal 335 abuts against the first insertion end 410 of the signal transmission structure 400. In another implementation, the second terminal 335 may be partially insert-molded into the insulation housing 331. To be specific, in this case, the insulation housing 331 may not be provided with the second movement space 3317, and the part that is of the second terminal 335 and that is located in the second movement space 3317 may be insert-molded into the insulation housing 331.

Similar to the configuration of the first terminal 334, the third electrical connection end 3351 of the second terminal 335 may also be located on the side that is of the insertion space 3314 and that is away from the second electrical connection end of the second terminal 335. The second terminal 335 may be partially located in the first movement space 3316 and partially located in the second movement space 3317 opposite to the first movement space 3316. In this way, a deformation force is evenly applied to all positions of the second terminal 335, resulting in a long service life of the second terminal 335 and good electrical connection reliability of the electrical connector 330.

In another implementation, the first terminal 334 may be a metal spring as a whole. The second terminal 335 may be a metal spring as a whole. For example, a metal strip in a specific shape may be first formed by cutting or another process, and then the first terminal 334 and the second terminal 335 in a specific bent shape are formed by a bending process.

In some implementations, when the signal transmission structure 400 is routed between the circuit board 310 and the insulation housing 331, the signal transmission structure 400 may be avoided at a position at which the second electrical connection end 3342 of the first terminal 334 or the fourth electrical connection end 3352 of the second terminal 335 extends out of the bottom surface 3312 of the insulation housing 331. For example, when the signal transmission structure 400 is routed on a side on which the first electrical connection end 3341 of the first terminal 334 is located, the fourth electrical connection end 3352 of the second terminal 335 and the second electrical connection end 3342 of the first terminal 334 may be located on a same side of the insertion space 3314, to avoid interference between the fourth electrical connection end 3352 of the second terminal 335 and the signal transmission structure 400.

There may be one or more first terminals 334. There may be one or more second terminals 335. A quantity of first terminals 334 and a quantity of second terminals 335 may be equal or may not be equal. For example, there are a plurality of first terminals 334, and the plurality of first terminals 334 are spaced apart in an extension direction of the insertion space 3314. There may also be a plurality of second terminals 335, and the plurality of second terminals 335 are spaced apart in the extension direction of the insertion space 3314.

In some implementations, a projection of the first electrical connection end 3341 of the first terminal 334 on a reference plane and a projection of the third electrical connection end 3351 of the second terminal 335 on the reference plane partially overlap in the extension direction of the insertion space 3314, and the reference plane is perpendicular to the extension direction of the insertion space 3314. In this way, a volume of the electrical connector 330 can be further reduced, facilitating miniaturization of the electronic device 1000. For example, the plurality of first terminals 334 and the plurality of second terminals 335 may be arranged alternately in the extension direction of the insertion space 3314. In other words, one second terminal 335 is arranged between any two adjacent first terminals 334, and one first terminal 334 is arranged between any two adjacent second terminals 335.

In another implementation, the electrical connector 330 may include only one of the first terminal 334 and the second terminal 335. When the signal transmission structure 400 is inserted into the electrical connector 330, the first terminal 334 or the second terminal 335 abuts against a side of the first insertion end 410 of the signal transmission structure 400.

As shown in FIG. 4b, the second side wall 3365 of the accommodation groove 3319 may be recessed in a direction away from the first side wall 3364, to form a first groove 3310. An opening of the first groove 3310 may be located on the second side wall 3365. The first groove 3310 may be in communication with the second movement space 3317.

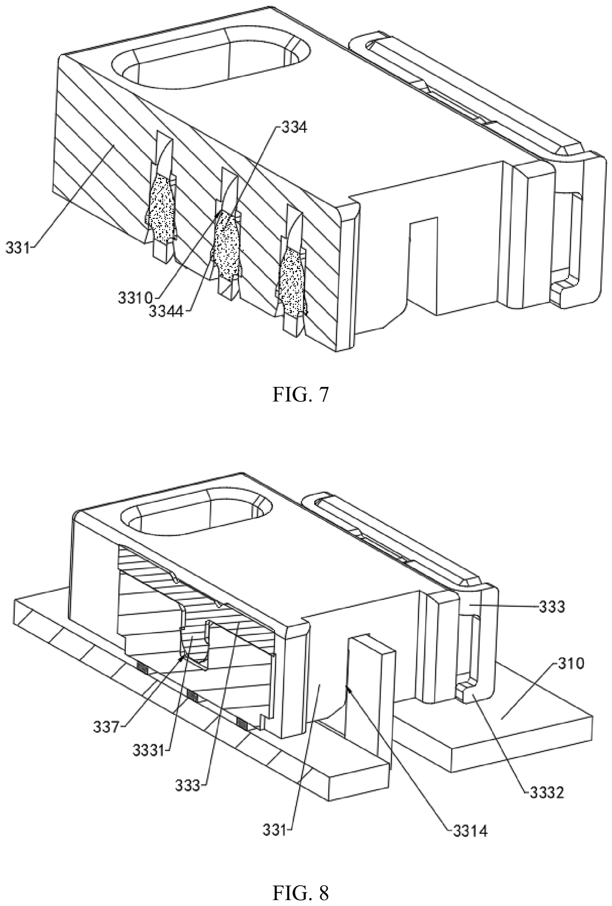

FIG. 7 is a cross-sectional view of the electrical connector 330 shown in FIG. 4c at a section line D-D from another angle in an implementation.

As shown in FIG. 4a and FIG. 7, the first terminal 334 may further include a protrusion 3344. When the first terminal 334 is fastened to the insulation housing 331, the protrusion 3344 may be located in the first groove 3310, and the protrusion 3344 of the first terminal 334 and the first groove 3310 may form a concave-convex fit. In a process of mounting the first terminal 334 to the insulation housing 331, the protrusion 3344 can assist in positioning, improving assembly efficiency. In another implementation, the protrusion 3344 of the first terminal 334 and a wall surface of the first groove 3310 may form an interference fit, to fasten the first terminal 334 to the insulation housing 331. The second terminal 335 may also be provided with a protrusion. For a specific configuration of the protrusion of the second terminal 335 and a manner of fastening the second terminal 335 to the insulation housing 331, refer to the configuration of the protrusion 3344 of the first terminal 334. Details are not described herein again.

In some implementations, when the first terminal 334 is an integrally formed metal terminal, a metal strip may be first formed by cutting, die casting, or another process, where a protrusion may be provided on the metal strip, and then the first terminal 334 with the protrusion 3344 is formed by a bending process.

In some implementations, a plurality of first terminals 334 may be connected by an insulation member (not shown in the figure), and the plurality of first terminals 334 form a structural component. In a process of mounting the first terminals 334 to the insulation housing 331, the insulation member can be used as a positioning structure, and a groove is provided in the accommodation groove 3319, for assembly positioning between the first terminals 334 and the insulation housing 331, in addition, a quantity of times of mounting the first terminals 334 can be reduced, so that the plurality of first terminals 334 can be all mounted to the insulation housing 331 at a time. In some implementations, a plurality of second terminals 335 may also be connected by an insulation member (not shown in the figure), and the plurality of first terminals 334 form a structural component.

In another implementation, when the first terminal 334 and the second terminal 335 are insert-molded into the insulation housing 331, the first terminal and the second terminal 335 may not be provided with protrusions. Structural shapes of the first terminal 334 and the second terminal 335 may be set based on a requirement. The first terminal 334 and the second terminal 335 in the accompanying drawings of this application are merely examples in an implementation.

FIG. 8 is a partial cross-sectional view of the structures shown in FIG. 3a at a section line E-E in an implementation.

As shown in FIG. 3a and FIG. 8, the reinforcement member 333 includes a first part 3331 fastened to the insulation housing 331 and a second part 3332 fastened to the circuit board 310. The first part 3331 and the second part 3332 may be spaced apart. It may be understood that reliability of a connection between the electrical connector 330 and the circuit board 310 can be enhanced by disposing the reinforcement member 333, thereby improving reliability of an electrical connection between the electrical connector 330 and the signal transmission structure 400.

For example, the reinforcement member 333 may be a structural component made of a metal material. In this way, the reinforcement member 333 can be fastened to the circuit board 310 by welding. For example, a material of the reinforcement member 333 may be aluminum, steel, copper, or another metal material.

The reinforcement member 333 may be fastened to the insulation housing 331 by concave-convex fitting. For example, the insulation housing 331 may include a recess 337, and a shape of the recess 337 may match that of the first part 3331. In this way, the first part 3331 can be located in the recess 337, and the first part 3331 and the recess 337 can form a concave-convex fit, so that the reinforcement member 333 is fastened to the insulation housing 331. In another implementation, the reinforcement member 333 may be fastened to the insulation housing 331 by adhesive bonding, screw connection, or the like.

There may be one or more reinforcement members 333. For example, there are two reinforcement members 333, and the two reinforcement members 333 are located on two sides of the insertion space 3314. In this way, force distribution in the electrical connector 330 is uniform. In another implementation, the reinforcement member 333 may be fastened to the insulation housing 331 at another position. This is described below in detail with reference to the accompanying drawings, and details are not described herein again.

The reinforcement member 333 may be in a "U" shape with two legs separately configured to be fastened to the circuit board 310, that is, one reinforcement member 333 may include two second parts 3332 for the circuit board 310, and the two second parts 3332 are located on a same side of the insertion space 3314. In another implementation, the two second parts 3332 may be respectively located on two sides of the insertion space 3314.

In another implementation, the reinforcement member 333 and the insulation housing 331 may be an integrated structural component formed by an insert molding process. The insert molding (insert molding) process is a molding process in which a prepared insert is placed in a mold and then a molten material is injected, for the molten material and the insert to be bonded and solidified, to obtain an integrated product.

In another implementation, the electrical connector 330 may not be provided with the reinforcement member 333, and the insulation housing 331 is fastened to the circuit board 310 by adhesive bonding or the like. It may be understood that, compared with adhesive bonding, the configuration of the reinforcement member 333 makes the insulation housing 331 unlikely to detach from the circuit board 310, resulting in good reliability of a connection between the insulation housing 331 and the circuit board 310.

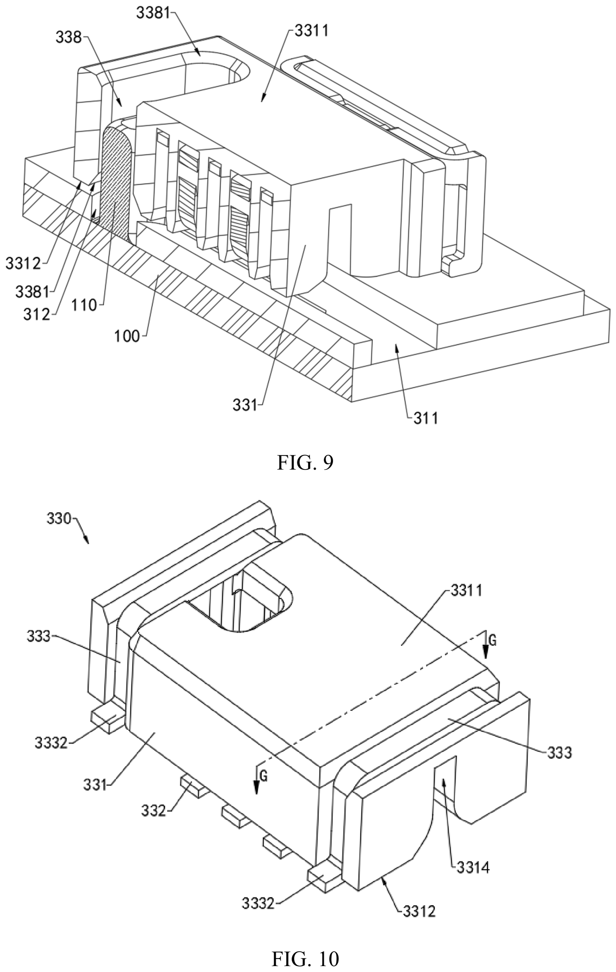

FIG. 9 is a partial cross-sectional view of the structures shown in FIG. 3a at a section line F-F in an implementation.

As shown in FIG. 3b and FIG. 9, the insulation housing 331 includes a positioning structure. The positioning structure can be configured to assist in positioning during mounting of the circuit board assembly 300, improving mounting efficiency. The positioning structure may be a through hole or a groove. For example, the insulation housing 331 is provided with a through hole 338, and two openings 3381 of the through hole 338 are respectively located on the top surface 3311 and the bottom surface 3312 of the insulation housing 331. When the circuit board 310 is fastened to the outer shell 100, the electronic device 1000 may include a positioning rod 110, and the positioning rod 110 may be fastened to an inner surface of the outer shell 100, that is, the positioning rod 110 and the circuit board 310 are mounted on a same side of the outer shell 100. The circuit board 310 may be provided with a second through hole 312, and the second through hole 312 and the through hole 338 are opposite to each other. The positioning rod 110 is located in the second through hole 312 and the through hole 338. The first through hole 311 and the second through hole 312 may be spaced apart or may be in communication. When the circuit board 310 is mounted on another structural component, the positioning rod 110 may be fastened to the another structural component. In other words, a position of the positioning rod 110 may be adjusted based on a mounting position of the circuit board 310, for the positioning rod 110 to assist in positioning in a process of mounting the circuit board assembly 300, improving mounting efficiency of the circuit board assembly 300.

In another implementation, the positioning structure may be a protrusion structure. In this case, a groove matching the positioning structure may be provided on the outer shell 100, to implement quick positioning.

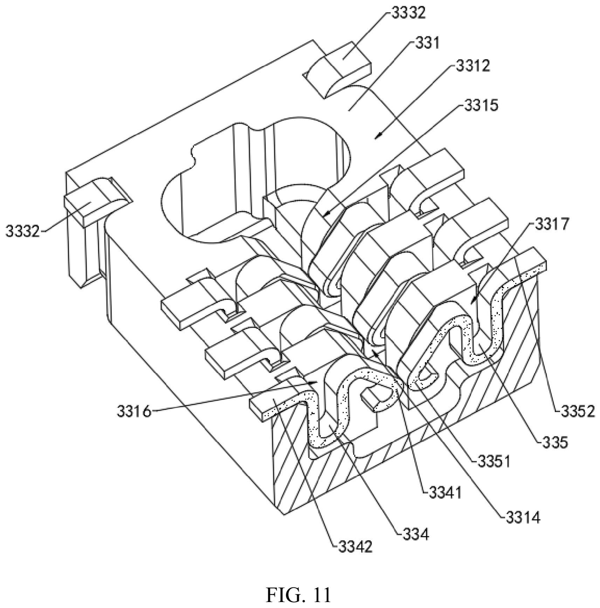

In some implementations, technical content that is the same as that of the electrical connector 330 in the foregoing implementations is not described again. FIG. 10 is a diagram of a structure of the electrical connector 330 shown in FIG. 2 in another implementation. FIG. 11 is a cross-sectional view of the electrical connector 330 shown in FIG. 10 at a section line G-G from another angle in an implementation.

As shown in FIG. 10 and FIG. 11, the electrical connector 330 may include an insulation housing 331, a terminal 332, and a reinforcement member 333. The insulation housing 331 includes a top surface 3311 and a bottom surface 3312 that face away from each other. The terminal 332 is fastened to the insulation housing 331. The terminal 332 includes a first electrical connection end electrically connected to the signal transmission structure 400 and a second electrical connection end electrically connected to the circuit board 310. The first electrical connection end of the terminal 332 is exposed out of the bottom surface 3312 of the insulation housing 331 and is configured to be electrically connected to the signal transmission structure 400. The second electrical connection end of the terminal 332 extends out of the bottom surface 3312 of the insulation housing 331 and is configured to be electrically connected to the circuit board 310.

For example, the insulation housing 331 includes an insertion space 3314. The insertion space 3314 may be provided to accommodate the first insertion end 410 of the signal transmission structure 400. An opening 3315 is provided in the bottom surface 3312 of the insulation housing 331, and the opening 3315 is in communication with the insertion space 3314.

For example, the terminal 332 may include a first terminal 334 and a second terminal 335. The first terminal 334 may include a first electrical connection end 3341 electrically connected to the signal transmission structure 400 and a second electrical connection end 3342 electrically connected to the circuit board 310. The second terminal 335 may also include a third electrical connection end 3351 electrically connected to the signal transmission structure 400 and a fourth electrical connection end 3352 electrically connected to the circuit board 310. A part of the first electrical connection end 3341 of the first terminal 334 and a part of the third electrical connection end 3351 of the second terminal 335 are located in the insertion space 3314 and are configured to be electrically connected to the first insertion end 410 of the signal transmission structure 400.

A part of the first electrical connection end 3341 of the first terminal 334 and a part of the third electrical connection end 3351 of the second terminal 335 may be located on two sides of the insertion space 3314. When the first insertion end 410 of the signal transmission structure 400 is inserted into the insertion space 3314, the first electrical connection end 3341 of the first terminal 334 and the third electrical connection end 3351 of the second terminal 335 may be respectively connected to two sides of the signal transmission structure 400. In this way, double-sided signal transmission can be implemented at the first insertion end 410 of the signal transmission structure 400. When a quantity of terminals 332 remains unchanged, compared with a solution of single-sided signal transmission, this technical solution can effectively reduce a volume of the electrical connector 330, thereby facilitating miniaturization of the electronic device 1000. In addition, the solution of double-row terminals 332 can also be compatible with a signal transmission structure 400 for single-sided signal output, making application of the electrical connector 330 less limited.

In some implementations, the first electrical connection end 3341 of the first terminal 334 and the second electrical connection end 3342 of the first terminal 334 may be located on a same side of the insertion space 3314. The third electrical connection end 3351 of the second terminal 335 and the second electrical connection end of the second terminal 335 may be located on a same side of the insertion space 3314. When the first insertion end 410 of the signal transmission structure 400 is inserted into the electrical connector 330, the first terminal 334 and the second terminal 335 are respectively located on two sides of the first insertion end 410.

The first electrical connection end 3341 of the first terminal 334 and the third electrical connection end 3351 of the second terminal 335 may be metal springs. For example, the first electrical connection end 3341 of the first terminal 334 and the third electrical connection end 3351 of the second terminal 335 are in a wavy shape. It may be understood that shapes of the first terminal 334 and the second terminal 335 may be designed based on a requirement. This is not limited in this application.

In some implementations, the insulation housing 331 may further include a first movement space 3316 and a second movement space 3317. Both the first movement space 3316 and the second movement space 3317 are in communication with the insertion space 3314 and are respectively located on two sides of the insertion space 3314. For configuration of the insertion space 3314, the first movement space 3316, and the second movement space 3317, refer to the configuration of the insertion space 3314, the first movement space 3316, and the second movement space 3317 in the foregoing embodiments. Details are not described herein again.

The first terminal 334 may be partially located in the first movement space 3316. The second terminal 335 may be partially located in the second movement space 3317. In this way, when the signal transmission structure 400 is inserted into the electrical connector 330, the first electrical connection end 3341 of the first terminal 334 and the third electrical connection end 3351 of the second terminal 335 abut against the signal transmission structure 400, so that the first movement space 3316 can provide space for deformation of the first terminal 334, and the second movement space 3317 can provide space for deformation of the second terminal 335.

In some implementations, the first electrical connection end 3341 of the first terminal 334 and the third electrical connection end 3351 of the second terminal 335 may be opposite to each other. To be specific, the first electrical connection end 3341 of the first terminal 334 and the third electrical connection end 3351 of the second terminal 335 may be completely or partially opposite to each other. For example, the first electrical connection end 3341 of the first terminal 334 and the third electrical connection end 3351 of the second terminal 335 are completely opposite to each other. In another implementation, the first electrical connection end 3341 of the first terminal 334 and the third electrical connection end 3351 of the second terminal 335 may be staggered.

In some implementations, a projection of the first electrical connection end 3341 of the first terminal 334 on a reference plane and a projection of the third electrical connection end 3351 of the second terminal 335 on the reference plane partially overlap in the extension direction of the insertion space 3314, and the reference plane is perpendicular to the extension direction of the insertion space 3314. In this way, a width of the electrical connector 330 in a first direction can be further reduced, and a volume of the electrical connector 330 can be reduced, facilitating miniaturization of the electronic device 1000.

There may be two reinforcement members 333. The two reinforcement members 333 are spaced apart in the extension direction of the insertion space 3314. Two second parts 3332 of the reinforcement member 333 may be located on two sides of the insertion space 3314. The two reinforcement members 333 are fastened to two ends of the insulation housing 331. It may be understood that a quantity and a shape of reinforcement members 333, and a position at which the reinforcement member 333 and the insulation housing 331 are connected may be designed based on an actual requirement. This is not limited in this application.

In this application, several electrical connectors 330 of different structures are described with reference to the accompanying drawings. The electrical connector 330 is electrically connected between the circuit board 310 and the signal transmission structure 400, and is configured to implement an electrical connection between the signal transmission structure 400 and the circuit board 310. The electrical connector 330 includes an insulation housing 331 and a terminal 332, the terminal 332 is fastened to the insulation housing 331, a first electrical connection end of the terminal 332 is exposed out of a bottom surface 3312 of the insulation housing 331 and is configured to be electrically connected to the signal transmission structure 400, a second electrical connection end of the terminal 332 extends out of the bottom surface 3312 of the insulation housing 331 and is configured to be electrically connected to the circuit board 310, and the bottom surface 3312 of the insulation housing 331 faces the circuit board 310. The signal transmission structure 400 may be electrically connected to the terminal 332 through the bottom surface 3312 of the electrical connector 330.

When the signal transmission structure 400 is arranged between the electrical connector 330 and the circuit board 310, the signal transmission structure 400 enters the accommodation groove 3319 through the opening 3315 and is electrically connected to the terminal 332. In this case, the signal transmission structure 400 is partially located between the circuit board 310 and the electrical connector 330, and the insulation outer shell 100 of the electrical connector 330 and the circuit board 310 can cooperate to abut against the signal transmission structure 400, so that the signal transmission structure 400 is fastened. In this way, compared with a BTB connector or a ZIF connector, the electrical connector 330 in this application does not require an additional press-fitting structure, effectively reducing a volume of the electrical connector 330, and facilitating miniaturization of the electronic device 1000.

It should be noted that embodiments in this application and features in embodiments may be combined with each other without a conflict, and any combination of features in different embodiments also falls within the protection scope of this application. In other words, the foregoing described plurality of embodiments may be further combined based on an actual requirement.

It should be noted that all the foregoing accompanying drawings are example illustrations of this application, and do not represent an actual size of a product. In addition, a size proportion relationship between the components in the accompanying drawings is not intended to limit an actual product in this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An electrical connector (330), configured for an electrical connection between a circuit board (310) and a signal transmission structure (400), comprising an insulation housing (331) and a terminal (332), wherein the terminal (332) is fastened to the insulation housing (331), an insertion space (3314) is provided inside the insulation housing, an opening (3315) is provided in a bottom surface (3312) of the insulation housing (331), the opening (3315) communicates the insertion space (3314) and an outside of the insulation housing (331), and the bottom surface (3312) of the insulation housing (331) faces the circuit board (310); and
a first electrical connection end of the terminal (332) is at least partially located in the insertion space (3314) and is configured to be electrically connected to the signal transmission structure (400), a second electrical connection end of the terminal (332) extends out of the bottom surface (3312) of the insulation housing (331) and is configured to be electrically connected to the circuit board (310), and when the electrical connector (330) is configured to be electrically connected to the signal transmission structure (400), the signal transmission structure (400) enters the insertion space (3314) through the opening (3315) and is connected to the first electrical connection end of the terminal (332).

2. The electrical connector (330) according to claim 1, wherein the terminal (332) comprises a first terminal (334) and a second terminal (335), and a part of the first electrical connection end (3341) of the first terminal (334) and a part of a third electrical connection end (3351) of the second terminal (335) are located on two sides of the insertion space (3314); and
when a first insertion end (410) of the signal transmission structure (400) is inserted into the insertion space (3314), the first electrical connection end (3341) of the first terminal (334) and the third electrical connection end (3351) of the second terminal (335) are respectively connected to two sides of the signal transmission structure (400).

3. The electrical connector (330) according to claim 2, wherein the insulation housing (331) is further provided with a first movement space (3316), the first movement space (3316) is in communication with the insertion space (3314) and is located on a side of the insertion space (3314), the first terminal (334) is partially located in the first movement space (3316), the first terminal (334) is further configured to abut against the first insertion end (410) of the signal transmission structure (400) when the first insertion end (410) of the signal transmission structure (400) is inserted into the insertion space (3314), and the first movement space (3316) is provided to provide space for deformation of the first terminal (334) when the first terminal (334) abuts against the first insertion end (410) of the signal transmission structure (400); and/or
the insulation housing (331) is further provided with a second movement space (3317), the second movement space (3317) is in communication with the insertion space (3314) and is located on a side that is of the insertion space (3314) and that is away from the first movement space (3316), the second terminal (335) is at least partially located in the second movement space (3317), the second terminal (335) is further configured to abut against the first insertion end (410) of the signal transmission structure (400) when the first insertion end (410) of the signal transmission structure (400) is inserted into the insertion space (3314), and the second movement space (3317) is provided to provide space for deformation of the second terminal (335) when the second terminal (335) abuts against the first insertion end (410) of the signal transmission structure (400).

4. The electrical connector (330) according to claim 2 or 3, wherein the first electrical connection end (3341) of the first terminal (334) is located on a side that is of the insertion space (3314) and that is away from the second electrical connection end (3342) of the first terminal (334); and/or
the third electrical connection end (3351) of the second terminal (335) is located on a side that is of the insertion space (3314) and that is away from a fourth electrical connection end (3352) of the second terminal (335).

5. The electrical connector (330) according to any one of claims 2 to 4, wherein there are a plurality of first terminals (334), the plurality of first terminals (334) are spaced apart in an extension direction of the insertion space (3314), there are a plurality of second terminals (335), and the plurality of second terminals (335) are spaced apart in the extension direction of the insertion space (3314); and
the plurality of first terminals (334) and the plurality of second terminals (335) are arranged alternately in the extension direction of the insertion space (3314).

6. The electrical connector (330) according to claim 2 or 3, wherein the first electrical connection end (3341) of the first terminal (334) and the second electrical connection end (3342) of the first terminal (334) are located on a same side of the insertion space (3314); and/or
the third electrical connection end (3351) of the second terminal (335) and a fourth electrical connection end (3352) of the second terminal (335) are located on a same side of the insertion space (3314).

7. The electrical connector (330) according to claim 6, wherein the first electrical connection end (3341) of the first terminal (334) and the third electrical connection end (3351) of the second terminal (335) are opposite to each other.

8. The electrical connector (330) according to any one of claims 2 to 6, wherein a projection of the first electrical connection end (3341) of the first terminal (334) on a reference plane and a projection of the third electrical connection end (3351) of the second terminal (335) on the reference plane partially overlap in the extension direction of the insertion space (3314), and the reference plane is perpendicular to the extension direction of the insertion space (3314).

9. The electrical connector (330) according to any one of claims 1 to 8, wherein the first electrical connection end of the terminal (332) is in a "V" shape, a "U" shape, an "S" shape, a wavy shape, or a paperclip shape.

10. The electrical connector (330) according to any one of claims 1 to 9, wherein the insulation housing (331) comprises a positioning structure, and the positioning structure is a through hole (338) or a groove.

11. The electrical connector (330) according to any one of claims 1 to 10, wherein the electrical connector (330) further comprises a reinforcement member (333) made of a metal material, the reinforcement member (333) is fastened to the insulation housing (331), and the reinforcement member (333) is configured to enhance connection strength between the electrical connector (330) and the circuit board (310).

12. A circuit board assembly (300), comprising a circuit board (310) and the electrical connector (330) according to any one of claims 1 to 11, wherein the electrical connector (330) is fastened to the circuit board (310).

13. The circuit board assembly (300) according to claim 12, wherein the circuit board (310) is provided with a first through hole (311), and the first through hole (311) and the electrical connector (330) are opposite to each other.

14. An electronic device (1000), comprising an outer shell (100) and the circuit board (310) assembly according to claim 12 or 13, wherein the circuit board (310) assembly is mounted in the outer shell (100).
